# FASCICULE DE BREVET EUROPEEN

(11) **EP 2 627 796 B1**
(45) Date de publication et mention de la délivrance du brevet: **11.06.2014**
(21) Numéro de dépôt: 11832099.3
(22) Date de dépôt: 11.10.2011
(51) Int. Cl.: C23C 14/10, C23C 14/30, C23C 28/04, G02B 1/10, G02B 1/04

(54) **ARTICLE COMPRENANT UNE COUCHE MESOPOREUSE PROTEGEE PAR UN REVETEMENT FAISANT BARRIERE AU SEBUM ET PROCEDE DE FABRICATION**
ELEMENT MIT EINER DURCH EINEN ALS SPERRE ZUM SEBUM WIRKENDEN ÜBERZUG GESCHÜTZTEN MESOPORÖSEN SCHICHT UND HERSTELLUNGSVERFAHREN DAFÜR
ITEM COMPRISING A MESOPOROUS LAYER PROTECTED BY A COATING ACTING AS A BARRIER TO THE SEBUM, AND PRODUCTION METHOD

(30) Priorité: 12.10.2010 FR 1058306
(43) Date de publication de la demande: 21.08.2013
(73) Titulaire: Essilor International (Compagnie Générale d'Optique), 94220 Charenton-le-Pont (FR)
(72) Inventeur: CADET, Mamonjy, F-94220 Charenton Le Pont (FR); FEUILLADE, Mathieu, Singapour 339346 (SG)
(74) Mandataire: Coralis Harle
(86) Numéro de dépôt international: PCT/FR2011/052373
(87) Numéro de publication internationale: WO 2012/049420

(56) Documents cités:
- WO-A1-2006/021698
- WO-A1-2009/004222
- WO-A2-2004/016822
- WO-A2-2010/001053

## Description

La présente invention concerne de manière générale des revêtements mésoporeux ayant un faible indice de réfraction, dont l'indice de réfraction a été stabilisé vis-à-vis des polluants extérieurs tels que le sébum. Ils sont principalement destinés à équiper des substrats en verre organique ou minéral, notamment dans le domaine de l'optique ophtalmique, en particulier des lentilles ophtalmiques pour des lunettes.

De plus en plus, on cherche à fonctionnaliser les articles en verre organique ou minéral en déposant à leur surface des revêtements de quelques nanomètres ou micromètres d'épaisseur destinés à leur conférer une propriété particulière selon l'application visée. Ainsi, il existe des couches à fonction antireflet, anti-abrasion, anti-rayure, antichoc, antibuée, antisalissure ou antistatique.

Un revêtement antireflet se définit comme un revêtement, déposé à la surface d'un article, qui améliore les propriétés anti-réfléchissantes de l'article final. Il permet de réduire la réflexion de la lumière à l'interface article-air sur une portion relativement large du spectre visible.

Selon les standards utilisés dans l'optique ophtalmique, un article à propriétés antireflet présente une valeur de réflexion Rv inférieure ou égale à 2,5 % par face.

Lorsqu'une couche mésoporeuse est utilisée dans un empilement antireflet, elle constitue généralement la couche externe de cet empilement. L'utilisation de couches mésoporeuses s'explique facilement dans le cas d'un revêtement antireflet monocouche, puisqu'il est préférable que ce revêtement ait une épaisseur optique de λ/4, λ désignant une longueur d'onde, et un indice de réfraction égal à la moyenne géométrique des indices de réfraction des milieux qui l'entourent, à savoir l'air et un substrat. Pour un substrat d'indice de réfraction égal à 1,5, sachant que l'indice de réfraction de l'air est égal à 1, il faudrait disposer d'une couche d'indice de réfraction 1,22. Cet indice de réfraction ne pouvant pas être obtenu en utilisant des couches minces solides, on cherche à s'en approcher au mieux en ayant recours à des couches poreuses, dont l'indice de réfraction est naturellement plus faible.

La préparation de revêtements mésoporeux à matrice à base de silice possédant un faible indice de réfraction du fait de leur porosité élevée est connue et a été décrite par exemple dans les demandes WO 2006/021698, WO 2007/088312 et WO 2007/090983, au nom du demandeur. La demande WO 2006/021698 décrit notamment l'utilisation de couches mésoporeuses dans des revêtements antireflet.

Dans le cas d'un revêtement antireflet multicouche, composé de couches de haut indice de réfraction et de bas indice de réfraction, utiliser une couche de très bas indice de réfraction en tant que couche externe de l'empilement est favorable à l'obtention d'un revêtement antireflet de grande efficacité. Les performances du revêtement antireflet sont encore accrues lorsque la couche de très bas indice de réfraction est déposée sur une couche de haut indice de réfraction.

En outre, si la couche mésoporeuse n'était pas utilisée en tant que couche externe, le dépôt de couches supplémentaires par voie liquide sur cette couche pourrait induire un comblement de sa porosité et donc une perte de ses propriétés de bas indice de réfraction.

Ce placement du revêtement mésoporeux en position externe le rend très sensible à des polluants extérieurs tels que le sébum par exemple. Après pollution de sa porosité par pénétration de divers polluants, l'indice de réfraction du revêtement mésoporeux augmente et on constate que ses performances antiréfléchissantes diminuent.

L'utilisation de couches protectrices ou barrières dans le domaine optique a déjà été décrite.

La demande WO 03/057641 décrit l'utilisation de couches de fluorures ou d'hydroxydes métalliques pour la protection d'une fine couche externe organique ou inorganique vis-à-vis d'espèces énergétiques et/ou réactives.

La demande WO 2004/016822 décrit l'utilisation de couches de silice déposées sous assistance ionique ayant typiquement une épaisseur de 10 nm pour stabiliser l'indice de réfraction d'une couche de SiOₓF_{y} sous-jacente. Ces couches protectrices préviendraient la pénétration de l'eau provenant de l'humidité ambiante au sein de la couche d'oxyfluorure de silicium, à l'origine d'une diffusion d'espèces fluorées hors de cette couche.

La demande WO 00/10934 décrit un procédé pour améliorer la durabilité d'un revêtement antireflet poreux, en l'occurence son adhésion et sa résistance à l'abrasion, consistant à déposer sur ledit revêtement une couche durcie de 5 à 250 nm d'épaisseur d'une composition comprenant des particules d'oxyde métallique et un tétraalkyl orthosilicate tel que le tétraméthoxysilane, puis un revêtement hydrophobe à base de polymères fluorés et d'organosilanes perfluoroalkylés ayant de préférence une épaisseur de 1 à 40 nm. Dans cette demande, la couche protectrice présente l'inconvénient d'être déposée par voie liquide.

Aucune solution n'a été proposée à ce jour pour stabiliser l'indice de réfraction d'un revêtement mésoporeux vis-à-vis de polluants extérieurs.

L'invention a donc pour objet un article comportant un revêtement mésoporeux dont l'indice de réfraction n'est pas affecté par la salissure et est stable dans le temps.

L'invention a aussi pour objet un article revêtu d'un revêtement antireflet comprenant une couche mésoporeuse de bas indice de réfraction dont l'indice de réfraction n'est pas affecté par la salissure et est stable dans le temps.

Un autre objet de l'invention est un procédé d'obtention d'un revêtement mésoporeux stabilisé, c'est-à-dire dont l'indice de réfraction est stable dans le temps et n'est pas affecté par la salissure.

Ces problèmes techniques ont été résolus selon l'invention en concevant une couche protectrice imperméable spécifique, capable de protéger la porosité d'un revêtement mésoporeux vis-à-vis de polluants extérieurs, faisant en particulier barrière au sébum, et lui permettant de conserver ses propriétés antireflet éventuelles.

Une couche barrière, dont la constitution et le mode de dépôt ont été mis au point par les inventeurs, est déposée directement sur le revêtement mésoporeux.

Ces objectifs sont donc atteints, selon l'invention, par un article, de préférence un article d'optique, comprenant un substrat ayant une surface principale revêtue d'un revêtement mésoporeux et d'un revêtement faisant barrière au sébum d'épaisseur inférieure ou égale à 20 nm, déposé directement sur le revêtement mésoporeux, comportant au moins une couche à base de silice, ladite couche à base de silice ayant une épaisseur d'au moins 5 nm, comprenant au moins 90 %, de préférence au moins 95 % et mieux 100 % en masse de silice, par rapport à la masse totale de la couche, et ayant été déposée par dépôt physique en phase vapeur, préférentiellement par évaporation sous vide.

L'invention concerne en outre un procédé d'obtention d'un article comportant un substrat ayant une surface principale revêtue d'un revêtement mésoporeux dont l'indice de réfraction est stable dans le temps, comprenant la formation par dépôt physique en phase vapeur, préférentiellement par évaporation sous vide d'un revêtement faisant barrière au sébum tel que défini ci-dessus directement sur ledit revêtement mésoporeux.

L'invention concerne aussi l'utilisation d'un revêtement faisant barrière au sébum tel que défini ci-dessus pour empêcher la pénétration de sébum dans la porosité d'un revêtement mésoporeux formé sur une surface principale du substrat d'un article.

Dans la présente demande, lorsqu'un article comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article, c'est-à-dire son revêtement le plus éloigné du substrat.

Dans la présente demande, un revêtement qui est "sur" un substrat/revêtement ou qui a été déposé "sur" un substrat/revêtement est défini comme un revêtement qui (i) est positionné au-dessus du substrat/revêtement, (ii) n'est pas nécessairement en contact avec le substrat/revêtement, c'est-à-dire qu'un ou plusieurs revêtements intermédiaires peuvent être disposés entre le substrat/revêtement et le revêtement en question (toutefois, il est de préférence en contact avec ledit substrat/revêtement), et (iii) ne recouvre pas nécessairement le substrat/revêtement complètement. Lorsque "une couche 1 est localisée sous une couche 2", on comprendra que la couche 2 est plus éloignée du substrat que la couche 1.

L'article préparé selon l'invention comprend un substrat, de préférence transparent, ayant au moins deux faces principales, dont l'une au moins comporte un revêtement mésoporeux stabilisé par un revêtement faisant barrière au sébum.

Un revêtement est considéré comme constituant une barrière efficace contre la pénétration de sébum dans un revêtement mésoporeux lorsque cette protection est effective pendant au moins 24 heures d'exposition permanente du revêtement mésoporeux au sébum. Ceci peut être vérifié expérimentalement en faisant appel à des techniques telles que la spectroscopie infrarouge, la microscopie optique ou l'étude de la stabilité dans le temps de l'indice de réfraction du revêtement mésoporeux.

Bien que l'article selon l'invention puisse être un article d'optique quelconque, tel qu'un écran, un vitrage pour l'industrie aéronautique, automobile, du bâtiment l'aménagement intérieur, une fibre optique, un isolant pour la microélectronique ou un miroir, il est de préférence une lentille optique, mieux une lentille ophtalmique, pour lunettes, ou une ébauche de lentille optique ou ophtalmique. La lentille peut être une lentille polarisée ou une lentille photochrome.

Le revêtement antireflet selon l'invention peut être formé sur au moins l'une des faces principales d'un substrat nu, c'est-à-dire non revêtu, ou sur au moins l'une des faces principales d'un substrat déjà revêtu d'un ou plusieurs revêtements fonctionnels.

Le substrat de l'article selon l'invention peut être un verre minéral ou organique, par exemple un verre organique en matière plastique thermoplastique ou thermodurcissable.

Des classes de substrats particulièrement préférées sont les poly(thiouréthanes), les polyépisulfures et les résines résultant de la polymérisation ou (co)polymérisation de bis allyl carbonates d'alkylène glycols. Ces derniers monomères sont vendus, par exemple, sous la dénomination commerciale CR-39^{®} par la société PPG Industries. Des lentilles commerciales correspondantes sont des lentilles ORMA^{®} ESSILOR.

Dans certaines applications, il est préférable que la surface principale du substrat soit revêtue d'un ou plusieurs revêtements fonctionnels préalablement au dépôt du revêtement mésoporeux. Ces revêtements fonctionnels classiquement utilisés en optique peuvent être, sans limitation, une couche de primaire antichoc, un revêtement anti-abrasion et/ou anti-rayures, un revêtement polarisé, un revêtement photochrome, antistatique ou un revêtement coloré, en particulier une couche de primaire antichoc revêtue d'une couche anti-abrasion et/ou anti-rayures.

Le revêtement mésoporeux est de préférence déposé directement sur le substrat ou sur un revêtement anti-abrasion et/ou anti-rayures.

Préalablement au dépôt du revêtement anti-abrasion et/ou anti-rayures, il est possible de déposer sur le substrat un revêtement de primaire améliorant la résistance au choc et/ou l'adhésion des couches ultérieures dans le produit final.

Les revêtements de primaire améliorant la résistance au choc et les revêtements résistant à l'abrasion et/ou aux rayures peuvent être choisis parmi ceux décrits dans la demande WO 2007/088312.

Avant le dépôt du revêtement mésoporeux sur le substrat éventuellement revêtu, par exemple d'un revêtement anti-abrasion et/ou anti-rayures, il est courant de soumettre la surface dudit substrat, éventuellement revêtue, à un traitement d'activation physique ou chimique, destiné à augmenter l'adhésion du revêtement mésoporeux. Ce pré-traitement est généralement conduit sous vide. Il peut s'agir d'un bombardement avec des espèces énergétiques et/ou réactives, par exemple un faisceau d'ions ("Ion Pre-Cleaning" ou "IPC"), d'un traitement par décharge corona, par effluvage, d'un traitement UV, ou d'un traitement par plasma sous vide, généralement un plasma d'oxygène ou d'argon. Il peut également s'agir d'un traitement de surface acide ou basique et/ou par solvants (eau ou solvant organique). Plusieurs de ces traitements peuvent être combinés. Ces pré-traitements peuvent aussi être réalisés sur la surface d'une ou plusieurs couches de l'empilement avant le dépôt de la couche ultérieure.

Par espèces énergétiques (et/ou réactives), on entend notamment des espèces ioniques ayant une énergie allant de 1 à 300 eV, préférentiellement de 1 à 150 eV, mieux de 40 à 150 eV. Les espèces énergétiques peuvent être des espèces chimiques telles que des ions, des radicaux, ou des espèces telles que des photons ou des électrons.

Le pré-traitement préféré de la surface du substrat est un traitement par bombardement ionique, effectué au moyen d'un canon à ions, les ions étant des particules constituées d'atomes de gaz dont on a extrait un ou plusieurs électron(s).

Le revêtement mésoporeux va maintenant être décrit. Il s'agit préférentiellement d'un revêtement mésoporeux sol-gel à matrice comprenant des chaînons -Si-O-Si-.

Préférentiellement, on utilise une matrice obtenue à partir d'une composition comprenant un précurseur comportant au moins un atome de silicium lié à 4 groupes hydrolysables (ou hydroxyle).

La matrice constituant le revêtement mésoporeux comprend également généralement des chaînons polysiloxane, comprenant des groupes hydrocarbonés liés à des atomes de silicium.

Dans la présente demande, les matériaux (revêtements ou films) mésoporeux sont définis comme des solides comportant dans leur structure des pores ayant une taille allant de 2 à 50 nm, appelés mésopores, c'est-à-dire qu'au moins une partie de leur structure comprend des mésopores. Ceux-ci ont préférentiellement une taille allant de 3 à 30 nm. Cette taille de pore est intermédiaire entre celle des macropores (taille > 50 nm) et celle des micropores (taille < 2 nm, matériaux de type zéolite). Ces définitions sont conformes à celles donnée par l'IUPAC Compendium of Chemistry Terminology, 2nd Ed., A. D. McNaught and A. Wilkinson, RSC, Cambridge, UK, 1997.

Les mésopores peuvent être vides, c'est-à-dire remplis d'air, ou seulement partiellement vides. Le revêtement est dit mésoporeux si au moins une partie de ce revêtement est mésoporeuse.

Les matériaux mésoporeux et leur préparation ont été largement décrits dans la littérature, notamment dans Science 1983, 220, 365371 ou The Journal of Chemical Society, Faraday Transactions 1985, 81, 545-548.

La préparation de revêtements mésoporeux à matrice comprenant des chaînons -Si-O-Si- (matrice à base de silice) est décrite plus en détail dans les demandes WO 2006/021698, WO 2007/088312 et WO 2007/090983 au nom du demandeur, qui sont incorporées ici par référence.

Le procédé classique de préparation de films mésoporeux est le procédé sol-gel. Il comprend la préparation d'un sol peu polymérisé d'un matériau inorganique tel que la silice, obtenu à partir d'un ou plusieurs précurseurs co-hydrolysés, tels que les tétraalcoxysilanes, en particulier le tétraéthoxysilane (TEOS), en conditions généralement acides en présence d'un agent porogène. Ce sol renferme également de l'eau, un solvant organique généralement polaire tel que l'éthanol, et éventuellement un catalyseur d'hydrolyse et/ou de condensation.

Un film de ce sol précurseur est alors déposé sur une surface principale d'un support, et le film déposé est consolidé thermiquement. L'élimination de l'agent porogène, lorsqu'il a été utilisé en quantité suffisante, forme un film mésoporeux.

Dans la présente demande, un matériau est qualifié de mésoporeux dès lors que l'agent porogène utilisé pour sa préparation a été éliminé au moins partiellement d'au moins une partie de ce matériau, c'est-à-dire qu'au moins une partie de ce matériau contient des mésopores au moins partiellement vides. De préférence, tous les mésopores du matériau sont vides.

Un sol utilisable dans l'invention pour former la matrice mésoporeuse à chaînons -Si-O-Si- comprend :
- au moins un agent précurseur inorganique de formule : Si(X)4 (I)
   dans laquelle les groupes X, identiques ou différents, sont des groupes hydrolysables préférentiellement choisis parmi les groupes alcoxy -O-R, en particulier alcoxy en C₁-C₄, acyloxy -O-C(O)R où R est un radical alkyle, préférentiellement en C₁-C₆, de préférence méthyle ou éthyle, et halogènes, tels que Cl, Br et I et les combinaisons de ces groupes; ou un hydrolysat de cet agent précurseur;
- au moins un solvant organique, au moins un agent porogène, de l'eau et éventuellement un catalyseur d'hydrolyse des groupes X.

De préférence, les groupes X sont des groupes alcoxy, et en particulier méthoxy ou éthoxy, et mieux éthoxy.

Les composés (I) préférés sont les orthosilicates de tétraalkyle. Parmi ceux-ci, on utilise avantageusement le tétraéthoxysilane (ou orthosilicate de tétraéthyle) Si(OC₂H₅)₄ noté TEOS, le tétraméthoxysilane Si(OCH₃)₄ noté TMOS, ou le tétraisopropoxysilane Si(OC₃H₇)₄ noté TPOS, et de préférence le TEOS.

Le milieu dans lequel se trouvent les agents précurseurs est en général un milieu acide, le caractère acide du milieu étant obtenu par addition, par exemple, d'un acide minéral, typiquement HCl ou un acide organique tel que l'acide acétique, de préférence HCl. Cet acide remplit le rôle de catalyseur d'hydrolyse et de condensation en catalysant l'hydrolyse des groupes hydrolysables des agents précurseurs,

Les solvants organiques ou le mélange de solvants organiques convenant pour la préparation du sol précurseur selon l'invention sont tous des solvants classiquement utilisés, et plus particulièrement les solvants polaires, notamment les alcanols comme le méthanol, l'éthanol, l'isopropanol, l'isobutanol, le *n*-butanol et leurs mélanges. Le solvant organique préféré est l'éthanol.

L'agent porogène du sol précurseur peut être un agent porogène amphiphile ou non amphiphile. Généralement, il s'agit d'un composé organique.

Comme agents porogènes non amphiphiles utilisables dans la présente invention, on peut citer les polymères synthétiques tels que les polyoxydes d'éthylène ou leurs éthers, les poly(alkylènoxy)alkyl-éthers les polyéthylène glycols, les copolymères diblocs ou triblocs d'oxyde d'éthylène (PEO) et d'oxyde de propylène (PPO).

L'agent porogène est de préférence un amphiphile du type tensioactif, tel que le bromure de cétyltriméthylammonium. Les composés tensioactifs utilisables dans la présente invention sont ceux décrits dans la demande WO 2007/088312.

L'étape de dépôt du film de sol précurseur sur la surface principale du support peut se faire par tout procédé classique par voie liquide, par exemple dépôt au trempé, dépôt par pulvérisation ou dépôt par céntrifugation, de préférence par centrifugation.

L'étape de consolidation de la structure du film de sol précurseur déposé consiste à terminer l'élimination du solvant ou mélange de solvants organiques du film de sol précurseur et/ou de l'excès éventuel d'eau et poursuivre la condensation de certains groupes silanol résiduels présents dans le sol, généralement par chauffage dudit film. De préférence, cette étape s'effectue par chauffage à une température ≤ 150 °C, de préférence ≤ 130 °C, mieux ≤ 120 °C et mieux encore ≤ 110 °C.

L'étape d'élimination de l'agent porogène peut être partielle ou totale, de préférence totale. Cette élimination est réalisée par toute méthode appropriée, par exemple par calcination à haute température (chauffage à une température généralement de l'ordre de 400 °C), mais elle est de préférence accomplie grâce à des méthodes permettant de travailler à basse température, c'est-à-dire à une température ≤ 150 °C, de préférence ≤ 130 °C, mieux ≤ 120 °C et mieux encore ≤ 110 °C. On emploie de préférence l'extraction par solvant.

Les différentes techniques d'élimination de l'agent porogène et leur mise en oeuvre sont décrites plus en détail dans la demande WO 2007/090983.

La matrice du matériau mésoporeux de l'invention présente de préférence un caractère hydrophobe, qui est préférentiellement obtenu en mettant en oeuvre au moins l'un des deux modes de réalisation suivants.

Selon un premier mode de réalisation, un caractère hydrophobe peut être conféré à la matrice en introduisant au moins un agent précurseur hydrophobe porteur d'au moins un groupe hydrophobe dans le sol précurseur précédemment défini avant l'étape de dépôt d'un film du sol précurseur.

Par groupes « hydrophobes », on entend, dans le cadre de la présente invention, des combinaisons d'atomes qui ne sont pas susceptibles de s'associer avec des molécules d'eau, notamment par liaison hydrogène. Ce sont généralement des groupes organiques non polaires, exempts d'atomes chargés. Les groupes alkyle, phényle, fluoroalkyle, perfluoroalkyle, (poly)fluoro alcoxy[(poly)alkylènoxy] alkyle, trialkylsilyloxy entrent donc dans cette catégorie. Les groupes alkyle sont les groupes hydrophobes préférés.

Les agents précurseurs hydrophobes sont préférentiellement ajoutés dans le sol précurseur sous forme de solution dans un solvant organique et sont préférentiellement choisis parmi les composés et les mélanges des composés de formules (II) ou (III) telles que décrites dans la demande WO 2007/090983.

Les agents précurseurs hydrophobes préférés sont des silanes, en particulier des alcoxysilanes, porteurs d'au moins un groupe hydrophobe directement en contact avec l'atome de silicium. Parmi les alcoxysilanes utilisables, on peut citer les alkyltrialcoxysilanes, tel que le méthyltriéthoxysilane (MTEOS, CH₃Si(OC₂H₅)₃), les vinylalcoxysilanes, les fluoroalkyl alcoxysilanes, et les arylalcoxysilanes. L'agent précurseur hydrophobe particulièrement préféré est le méthyltriéthoxysilane (MTEOS).

Selon un deuxième mode de réalisation, qui est le mode de réalisation préféré, un caractère hydrophobe peut être conféré à la matrice à chaînons -Si-O-Si- (à base de silice) de l'invention en traitant le film mésoporeux dont la préparation est décrite ci-dessus par au moins un composé réactif hydrophobe porteur d'au moins un groupe hydrophobe. Le composé réactif hydrophobe est réactif vis-à-vis des groupes silanol de la matrice et un traitement par ce composé conduit à une matrice de silice dont au moins une partie des groupes silanol ont été dérivatisés en groupes hydrophobes.

La définition des groupes hydrophobes est la même que celle utilisée pour les agents précurseurs hydrophobes définis précédemment.

Cette étape additionnelle de traitement, appelée "greffage post-synthétique", est réalisée après l'étape de dépôt d'un film du sol précurseur sur une surface principale du support ou après l'étape de consolidation du film déposé. Elle peut être réalisée au cours de l'étape d'élimination de l'agent porogène, après l'étape d'élimination de l'agent porogène, ou même avant l'étape d'élimination de l'agent porogène.

Les composés réactifs hydrophobes porteurs d'au moins un groupe hydrophobe convenant particulièrement pour la présente invention sont des composés d'un métal ou métalloïde tétravalent, préférentiellement du silicium, comportant au moins une fonction capable de réagir avec les groupes hydroxyle restants dans le film, en particulier une fonction Si-CI, Si-NH-, Si-OR où R est un groupe alkyle, de préférence en C₁-C₄.

De préférence, ledit composé réactif hydrophobe est choisi parmi les composés et les mélanges de composés de formule (IX) décrite dans la demande WO 2007/088312.

Le composé réactif hydrophobe particulièrement préféré est le 1,1,1,3,3,3-hexaméthyldisilazane (CH₃)₃Si-NH-Si(CH₃)₃, noté HMDS.

Cette étape de greffage post-synthétique est décrite plus en détail dans les demandes US 2003/157311 et WO 2007/088312.

Cependant, les revêtements selon l'invention ont de préférence une matrice comprenant des chaînons -Si-O-Si- préparée à partir d'un sol ne contenant pas d'agent précurseur hydrophobe porteur d'au moins un groupe hydrophobe. Selon ce mode de réalisation, la matrice du revêtement mésoporeux formée lors de l'étape initiale de polymérisation n'est pas une matrice ayant un caractère hydrophobe, mais elle acquiert ce caractère suite à un post-traitement hydrophobe.

Les revêtements mésoporeux de l'invention ayant une matrice présentant un caractère hydrophobe démontrent une meilleure stabilité dans le temps de leurs propriétés, en particulier de leur indice de réfraction vis-à-vis de l'humidité ambiante.

Dans leur état final, les films mésoporeux de l'invention ont une épaisseur qui n'est pas particulièrement limitée, et qui peut être adaptée en fonction du but recherché. Généralement, ils ont une épaisseur maximale de l'ordre de 1 µm, et généralement une épaisseur allant de 50 nm à 1 µm, préférentiellement de 50 à 500 nm et mieux encore de 50 à 150 nm.

Le revêtement mésoporeux de l'invention peut être un revêtement multicouche, c'est-à-dire composé de plusieurs couches mésoporeuses déposées directement les unes sur les autres. Dans ce cas, le revêtement faisant barrière au sébum est déposé directement sur la couche mésoporeuse externe (la plus éloignée du substrat) du revêtement mésoporeux.

Selon un mode de réalisation, le revêtement mésoporeux constitue un revêtement antireflet monocouche. Lorsqu'il,constitue un revêtement antireflet monocouche, le revêtement mésoporeux de l'invention possède de préférence une épaisseur allant de 80 à 130 nm, de préférence de 90 à 120 nm, mieux de 95 à 110 nm, afin de minimiser la réflexion pour une longueur d'onde de l'ordre de 540 nm, à laquelle la sensibilité de l'oeil est maximale.

Bien que la couche à base de silice du revêtement faisant barrière au sébum puisse participer à l'efficacité de l'empilement antireflet, il est considéré dans la présente demandes, du fait de sa faible épaisseur , qu'elle constitue une couche distincte ne faisant pas partie du revêtement antireflet, lorsque l'article selon l'invention en comprend un.

L'indice de réfraction du revêtement mésoporeux de l'invention est inférieur ou égal à 1,45, mieux inférieur ou égal à 1,40. Il constitue donc une couche de bas indice de réfraction, suite à l'élimination de l'agent porogène au sein des mésopores. Le revêtement mésoporeux peut comprendre plusieurs couches mésoporeuses.

Dans la présente demande, une couche est dite couche de haut indice de réfraction (HI) lorsque son indice de réfraction est supérieur à 1,55, de préférence supérieur ou égal à 1,6, mieux supérieur ou égal à 1,8 et encore mieux supérieur ou égal à 2,0. Une couche est dite couche de bas indice de réfraction (BI) lorsque son indice de réfraction est inférieur ou égal à 1,55, de préférence inférieur ou égal à 1,50, mieux inférieur ou égal à 1,45. Sauf indication contraire, les indices de réfraction auxquels il est fait référence dans la présente invention sont exprimés à 25 °C pour une longueur d'onde de 630 nm.

Le revêtement mésoporeux est déposé préférentiellement sur une couche antiabrasion d'épaisseur supérieure à 1 micron, de préférence supérieure ou égale à 2 microns, à haut indice de réfraction (typiquement supérieur ou égal à 1,55, mieux supérieur ou égal à 1,60).

Selon un mode de réalisation de l'invention, le revêtement mésoporeux est formé sur une couche de haut indice de réfraction, préalablement déposée sur le substrat, et forme ainsi une couche de bas indice de réfraction d'un revêtement antireflet bicouche ou multicouche de plus de deux couches, comme décrit dans la demande WO 2006/021698. La couche HI est de préférence obtenue par durcissement d'une composition comprenant un hydrolysat d'un alcoxysilane, en particulier d'un epoxysilane, préférentiellement un époxytrialcoxysilane et de colloïdes haut indice de réfraction ou de précurseurs de ceux-ci. En particulier, les colloïdes peuvent être des colloïdes de TiO₂, ZrO₂, Sb₂O₅, SnO₂, WO₃, Al₂O₃.
Cette couche HI présente une épaisseur variant préférentiellement de 10 à 200 nm, mieux de 80 à 150 nm.

Cette couche HI peut aussi être une couche HI d'un empilement antireflet comprenant plusieurs couches alternées de haut indice de réfraction et bas indice de réfraction, notamment lorsque l'empilement antireflet est multicouche.

Selon un mode de réalisation, l'article de l'invention comprend un revêtement antireflet bicouche composé d'une couche de haut indice de réfraction (typiquement n = 1,7 à 1,8) et d'une couche mésoporeuse selon l'invention (typiquement n = 1,3 à 1,4), revêtu d'un revêtement faisant barrière au sébum, de préférence une couche à base de silice selon l'invention (typiquement n = 1,45 à 1,55).

De préférence, le facteur moyen de réflexion dans le domaine visible Rₘ (400-700 nm) et/ou le facteur moyen de réflexion lumineuse Rᵥ (moyenne pondérée de la réflexion spectrale sur l'ensemble du spectre visible entre 380 et 780 nm) d'un article selon l'invention est (sont) inférieur(s) à 2 % par face, mieux inférieur(s) à 1 % par face et encore mieux inférieur(s) à 0,75 % par face de l'article. L'homme du métier adapte les épaisseurs et les indices des couches en conséquence. Dans la présente demande, le "facteur moyen de réflexion" Rₘ et le "facteur de réflexion lumineuse" Rᵥ sont tels que définis dans la norme ISO 13666:1998, et mesurés conformément à la norme ISO 8980-4.

Dans la présente demande, le revêtement faisant barrière au sébum sera couramment nommé "couche barrière" ou "couche imperméable au sébum".

Le sébum auquel le revêtement selon l'invention fait barrière contient comme constituant principal l'acide oléique, et ce qu'il s'agisse d'un sébum naturel ou artificiel. Le sébum naturel contient généralement 20-30 % d'acide oléique.

Le revêtement faisant barrière au sébum comporte au moins une couche à base de silice comprenant au moins 90 % en masse de silice, par rapport à la masse totale de la couche, de préférence au moins 95 % en masse de silice. Dans une réalisation optimale, il comprend 100 % en masse de silice.

Lorsque la couche à base de silice ne comprend pas uniquement de la silice, elle comprend d'autres matériaux qui sont préférentiellement des matériaux diélectriques tels que des oxydes métalliques, notamment de l'alumine (Al₂O₃). On peut également utiliser de la silice dopée au fluor.

De préférence, les mélanges de silice avec d'autres composés sont tels que l'indice de réfraction de la couche à base de silice résultante est ≤ 1,55.

Lorsqu'une couche à base de silice comprenant un mélange de SiO₂ et d'Al₂O, est utilisée, elle comprend préférentiellement de 1 à 10 %, mieux de 1 à 8 % et encore mieux de 1 à 5 % en masse d'Al₂O₃ par rapport à la masse totale de SiO₂ + Al₂O₃ dans cette couche. Par exemple, SiO₂ dopée avec 4 % ou moins d'Al₂O₃ en masse, ou SiO₂ dopée avec 8 % d'Al₂O₃ peuvent être employés. Des mélanges SiO₂/Al₂O₃ disponibles dans le commerce peuvent être utilisés, tels que le LIMA^{®} commercialisé par Umicore Materials AG (indice de réfraction n = 1,48-1,50 à 550 nm), ou la substance L5^{®} commercialisée par Merck KGaA (indice de réfraction n =1,48 à 500 nm).

Selon un mode de réalisation de l'invention, le revêtement faisant barrière au sébum consiste en ladite couche à base de silice.

Cependant, le revêtement faisant barrière au sébum peut aussi être un revêtement multicouche, comprenant d'autres couches que la couche à base de silice, par exemple plusieurs couches minérales, de préférence à base de silice, et/ou un revêtement antisalissure utilisé en tant que couche externe de l'empilement.

Selon un mode de réalisation, le revêtement faisant barrière au sébum comprend ladite couche à base de silice, revêtue d'un revêtement antisalissure.

L'utilisation d'un revêtement antisalissure de quelques nanomètres d'épaisseur en tant que constituant de la couche barrière améliore son efficacité vis-à-vis d'une contamination du revêtement mésoporeux par le sébum, et permet d'utiliser une couche à base de silice plus fine qu'en l'absence de revêtement antisalissure pour obtenir des performances comparables en termes de protection.

Sans vouloir être liés par une théorie, les inventeurs pensent que cette amélioration est due à l'ajout d'une épaisseur de couche supplémentaire limitant la pénétration du sébum grâce à ses propriétés de surface oléophobes.

Les revêtements antisalissure, également nommés revêtements hydrophobes et/ou oléophobes ou top-coats, réduisent la sensibilité de l'article à la salissure, par exemple vis-à-vis des dépôts graisseux. Comme cela est connu, ces revêtements externes hydrophobes et/ou oléophobes sont obtenus par application, sur la surface du revêtement anti-reflet de composés diminuant l'énergie de surface de l'article.

Les revêtements antisalissure utilisables sont préférentiellement ceux décrits dans la demande WO 2009/047426, qui est incorporée ici par référence. Ils sont principalement obtenus à partir de compositions polymérisables contenant des composés à base de silanes ou silazanes porteurs de groupements fluorés (fluorosilanes ou fluorosilazanes), en particulier de groupements perfluorocarbone ou perfluoropolyéther.

Des compositions commerciales permettant de préparer des revêtements hydrophobes et/ou oléophobes sont la composition KY130^{®} (répondant à la formule du brevet JP 2005-187936) ou la composition OPTOOL DSX^{®}, commercialisée par DAIKIN INDUSTRIES (répondant à la formule du brevet US 6,183,872).

L'application des composés diminuant l'énergie de surface de l'article est classiquement effectuée par trempé dans une solution du composé, par centrifugation ou dépôt en phase vapeur.

Généralement, le revêtement antisalissure a une épaisseur inférieure à 10 nm, de préférence allant de 2 à 10 nm, mieux de 2 à 5 nm, mieux encore allant de 2 à 4 nm.

De préférence, le revêtement externe hydrophobe et/ou oléophobe a une énergie de surface égale ou inférieure à 14 mJ/m², de préférence égale ou inférieure à 13 mJ/m², mieux égale ou inférieure à 12 mJ/m². Des composés présentant cette énergie de surface sont généralement des alkoxysilanes comprenant des chaînons perfluoropolyéthers.

Le revêtement faisant barrière au sébum a une épaisseur inférieure ou égale à 20 nm mais supérieure ou égale à 5 nm. Lorsque l'épaisseur du revêtement faisant barrière au sébum devient trop importante, il risque de perturber les propriétés du revêtement mésoporeux, notamment d'amoindrir ses éventuelles propriétés antireflet en augmentant le niveau de réflexion. Lorsque l'épaisseur du revêtement faisant barrière au sébum devient trop faible, il risque au contraire de devenir perméable au sébum.

L'épaisseur minimale du revêtement faisant barrière au sébum dépend des conditions de dépôt de ce revêtement, et notamment des conditions de dépôt de sa couche à base de silice. Ainsi, lorsque l'on a recours à une assistance ionique lors du dépôt (décrite ci-dessous), on pourra utiliser un revêtement faisant barrière au sébum moins épais pour une protection comparable, celui-ci étant plus dense.

Les inventeurs ont par ailleurs constaté que la continuité physique de la couche barrière imperméable au sébum selon l'invention était indispensable à la protection de la porosité contre la pénétration de sébum. En cas de rayure de la couche barrière, la protection n'est plus assurée et le sébum s'imprègne à travers l'ouverture.

La couche à base de silice selon l'invention possède une épaisseur allant de 5 à 20 nm, de préférence de 8 à 20 nm, mieux de 10 à 20 nm. Selon un mode de réalisation, son épaisseur est supérieure à 10 nm. Lorsque l'épaisseur de ladite couche à base de silice est inférieure à 10 nm, l'article comprend en outre, de préférence, un revêtement antisalissure ayant une épaisseur d'au moins 2 nm.

Lorsque le revêtement faisant barrière au sébum comprend un revêtement antisalissure, la couche à base de silice selon l'invention possède de préférence une épaisseur supérieure ou égale à 8 nm, mieux supérieure ou égale à 10 nm.

Lorsque le revêtement faisant barrière au sébum est constitué de la couche à base de silice selon l'invention, cette dernière possède de préférence une épaisseur allant de 10 à 20 nm.

De préférence, la couche à base de silice du revêtement faisant barrière au sébum est directement déposée sur le revêtement mésoporeux, c'est-à-dire qu'elle est en contact avec lui. Cette couche doit impérativement être déposée par dépôt physique en phase vapeur (PVD), de préférence par évaporation sous vide ou par pulvérisation cathodique, idéalement par évaporation sous vide.

Dans le cas contraire, par exemple lors de formation d'une couche à base de silice par voie liquide (trempage, centrifugation...), on obtient une couche perméable, qui ne permet pas d'empêcher la pénétration de sébum dans le revêtement mésoporeux.

Une application de l'invention se situe donc également dans le domaine de la microélectronique.

Les inventeurs ont constaté que le dépôt d'un revêtement faisant barrière au sébum par dépôt physique en phase vapeur sur le revêtement mésoporeux ne modifiait pas (ou très peu) l'indice de réfraction et la constante diélectrique de ce dernier, ce qui signifie que la porosité du revêtement mésoporeux n'est pas comblée par le dépôt sous vide d'une couche barrière. Un dépôt par PVD de la couche barrière permet donc de conserver les propriétés de bas indice de réfraction et plus généralement de basse constante diélectrique du revêtement mésoporeux sous-jacent.

De plus, le dépôt par traitement sous vide permet un contrôle de l'épaisseur de la couche barrière à quelques manomètres près, ce qui n'est pas le cas des dépôts par voie liquide. Le contrôle de ces épaisseurs est indispensable, notamment lors de la réalisation d'empilements antireflet. Lorsque le revêtement faisant barrière au sébum comprend d'autres couches minérales que la couche à base de silice selon l'invention, celles-ci sont préférentiellement déposées par dépôt physique en phase vapeur.

Il est possible de réaliser une étape de traitement avec des espèces énergétiques telles que définies précédemment, de façon concomitante au dépôt d'une ou plusieurs des différentes couches de l'empilement, en particulier en ayant recours à une assistance ionique, de préférence par des ions oxygène.

La technique du dépôt sous assistance ionique ou "IAD" (pour Ion Assisted Déposition) est décrite notamment dans la demande de brevet WO2009004222.

L'évaporation sous assistance ionique consiste à déposer un film d'un matériau sur un substrat par évaporation sous vide en bombardant simultanément la surface de la couche en formation avec un faisceau d'ions positifs émis par un canon à ions, les ions étant des particules constituées d'atomes de gaz dont on a extrait un ou plusieurs électron(s), formés à partir d'un gaz rare, d'oxygène ou d'un mélange de deux ou plus de ces gaz. Le bombardement ionique provoque un réarrangement atomique dans la couche en cours de dépôt, ce qui permet de la tasser pendant qu'elle est en train d'être formée. Outre une densification, l'IAD permet d'améliorer l'adhérence des couches déposées et d'augmenter légèrement leur indice de réfraction.

Ainsi, de façon optionnelle, la couche faisant barrière au sébum, et de préférence la couche à base de silice selon l'invention, est déposée sous assistance ionique (IAD). Le dépôt de cette couche sous assistance ionique est préférentiellement réalisé lorsque son épaisseur est inférieure à 10 nm.

L'invention est illustrée, de façon non limitative, par les exemples suivants. Sauf indication contraire, les indices de réfraction sont donnés pour une longueur d'onde de 630 nm et T = 20-25°C.

### EXEMPLES

### A) Réactifs et matériel utilisés pour synthétiser les revêtements mésoporeux

Le TEOS, de formule Si(OC₂H₅)₄, a été employé en tant qu'agent précurseur inorganique de formule (I), le CTAB de formule C₁₆H₃₃N(CH₃)₃Br a été employé en tant qu'agent porogène tensioactif et l'hexaméthyldisilazane (HMDS) a été employé en tant que composé réactif hydrophobe.

Les sols ont été préparés en utilisant l'éthanol absolu en tant que solvant organique et une solution aqueuse d'acide chlorhydrique diluée à 0,1 M (de façon à obtenir un pH=1,25) en tant que catalyseur d'hydrolyse.

Les revêtements ont été déposés sur des verres comprenant un substrat de lentille MR8 (résine thiouréthane d'indice de réfraction égal à 1,59) ou ORMA^{®} ESSILOR (CR-39^{®}), d'indice de réfraction égal à 1,50, de 1,1 mm d'épaisseur, de rayon de courbure compris entre 80 et 180 mm et de diamètre 65 à 70 mm, ou bien sur des substrats en silicium (wafers). Les lentilles MR8 ou ORMA^{®} sont revêtues du revêtement anti-abrasion et anti-rayurés divulgué dans l'exemple 3 du brevet EP 0614957 (d'indice de réfraction égal à 1,48 et de 3,5 µm d'épaisseur), à base de GLYMO, DMDES, silice colloïdale et acétylacétonate d'aluminium, ou bien du revêtement anti-abrasion et/ou anti-rayure constitué d'une matrice polysiloxane et d'un colloïde haut indice (d'indice de réfraction égal à 1,60 et de 3,5 µm d'épaisseur). Dans les exemples 5 et 6, une couche de revêtement antireflet de haut indice de réfraction obtenue à partir d'une composition comprenant un hydrolysat de GLYMO et un colloïde de titane sous forme rutile (indice de la composition durcie : n∼1,76) de 150 nm d'épaisseur est déposée sur le revêtement anti-abrasion.

### B) Préparation des revêtements mésoporeux à matrice comprenant des chaînons -Si-O-Si-rendue hydrophobe par greffage post-synthétique

Le sol précurseur a été préparé en mélangeant réactifs et solvants dans les proportions molaires suivantes : TEOS (50 mL), EtOH (50 mL), HCl (0,1 N, 20,5 mL). L'ensemble est chauffé pendant 1 h à 60 °C pour hydrolyser les silanes. Après refroidissement, on obtient 120,5 mL d'une solution mère ayant une teneur en extrait sec de 14,5 % en masse. 15 mL de celle-ci sont ensuite dilués par une solution de 1,02 g de CTAB dans 100 mL d'éthanol, conduisant à une solution ayant une teneur en extrait sec de 2,5 % en masse dans laquelle le rapport molaire CTAB/TEOS est égal à 0,1. Elle est laissée à agiter une nuit avant dépôt par centrifugation sur le verre organique ORMA^{®} ou MR8 tel que décrit ci-dessus.

Le film subit ensuite un traitement thermique destiné à avancer le degré de polymérisation du réseau (consolidation). Le substrat revêtu du film obtenu dans le paragraphe 2 ci-dessus est consolidé thermiquement dans une étuve 75°C pendant 15 minutes puis à 100 °C pendant 3 heures, puis l'agent porogène est éliminé par extraction en plaçant le substrat revêtu du film consolidé dans la cuve d'un sonicateur de marque Elmasonic, contenant de l'isopropanol, à température ambiante pendant 15 min.

Le substrat revêtu du film mésoporeux est alors introduit pendant 15 minutes dans la cuve d'un bac à ultrasons de marque Elmasonic, contenant de l'hexamethyl disilazane (HMDS), à température ambiante. Les verres sont ensuite rincés à l'alcool isopropylique pour éliminer l'excès d'HMDS. Cette étape d'hydrophobation post-synthétique est décrite plus en détail dans les demandes WO 2007088312 et WO 2006021698. Elle permet d'obtenir une couche mésoporeuse d'environ 100 nm d'épaisseur et présentant un indice de réfraction allant de 1,31 à 1,33. Les substrats ainsi revêtus sont conservés dans une étuve chauffée à 60°C.

Les articles d'optique des exemples 1-4 possèdent un revêtement antireflet monocouche, alors que les articles d'optique des exemples 5-6 possèdent un revêtement antireflet bicouche (couche HI / couche mésoporeuse).

### C) Dépôt du revêtement faisant barrière au sébum

Les revêtements faisant barrière au sébum utilisés dans les exemples selon l'invention comprennent une couche de silice (SiO₂, d'indice de réfraction 1,47) et éventuellement un revêtement antisalissure fluoré (Optool DSX^{®}).

Ces revêtements sont déposés par évaporation dans une enceinte sous vide sur une machine de dépôt MC380 ou 1200DLF Satis, sans réaliser de traitement d'activation préalable de la surface du revêtement mésoporeux. Le dépôt de SiO₂ est effectué par évaporation au moyen d'un canon à électrons (Pression moyenne pendant le dépôt : 3,55.10⁻³ Pa, vitesse de dépôt : 0,15 nm/s, puissance du canon à électrons : 20 %). Le revêtement antisalissure est déposé en utilisant une source thermique à effet Joule (Pression moyenne pendant le dépôt : 1,84.10⁻³ Pa, vitesse de dépôt : 0,40 nm/s, puissance effet Joule : 12 %).

### D) Exemples comparatifs

Dans les exemples comparatifs C1 à C10, la couche de silice déposée par évaporation de silice du revêtement faisant barrière au sébum est remplacée par une couche de MgF₂, par une couche de silice d'épaisseur ≤ 5 nm déposée par évaporation, par une couche d'Optool DSX^{®}, ou supprimée. Le dépôt de MgF₂ est réalisé par évaporation à froid par canon à électrons dans les mêmes conditions que pour le dépôt de silice.

Dans les exemples comparatifs C11 et C12, la couche barrière de silice a été déposée non pas par dépôt physique en phase vapeur, mais par voie liquide.

Dans l'exemple comparatif C11, la couche barrière est une couche de silice obtenue par technique sol gel, par condensation du tétraméthoxysilane (TMOS), de la façon suivante : Dans un bécher sous agitation sont introduits le tétraméthoxysilane (12,58 g) et de l'éthanol (10 g). L'agitation est poursuivie 2-3 minutes, et l'acide chlorhydrique 0,1 N (7,41 g) est ajouté. L'agitation est poursuivie 30 minutes et 10 g d'éthanol sont rajoutés. La solution, qui présente une teneur en extrait sec de 12,8 % en masse, est diluée de façon à obtenir une teneur en extrait sec de 1 % en masse. Cette solution est ensuite déposée par centrifugation sur le revêtement mésoporeux (2500 tr/min, 20 s, 2000 acc) puis polymérisée pendant 30 minutes à 120°C.

Dans l'exemple comparatif C12, la couche barrière est une couche de silice obtenue par technique sol gel, par condensation du tétraméthoxysilane (TMOS) en présence d'un colloïde de silice (NALCO^{®} 1034A, taille moyennes des nanoparticules de silice : 20 nm) et d'acétylacétonate d'aluminium. Cette couche est préparée conformément au mode opératoire présenté dans la demande WO 00/10934 pour les exemples 1 et 4.

### E) Constitution des articles d'optique conformes à l'invention ou comparatifs

### Empilements substrat / revêtement anti-abrasion / revêtement mésoporeux / couche barrière

Exemple 1 : couche barrière de silice (dépôt par évaporation) de 10 nm d'épaisseur
Exemple 2 : couche barrière de silice (dépôt par évaporation) de 8 nm d'épaisseur
Exemple 3 : couche barrière de silice (dépôt par évaporation) de 6 nm d'épaisseur + couche d'Optool DSX^{®} de 2 nm d'épaisseur
Exemple 4 : couche barrière de silice (dépôt par évaporation) de 10 nm d'épaisseur + couche d'Optool DSX^{®} de 2 nm d'épaisseur

Exemple comparatif C1 : pas de couche barrière
Exemple comparatif C2 : couche barrière de silice (dépôt par évaporation) de 2 nm d'épaisseur
Exemple comparatif C3 : couche barrière de silice (dépôt par évaporation) de 4 nm d'épaisseur
Exemples comparatifs C4 à C7 : couche barrière de MgF₂ de 2, 4, 6 et 8 nm d'épaisseur
Exemple comparatif C8 : couche barrière d'Optool DSX^{®} de 2 nm d'épaisseur
Exemple comparatif C9 : couche barrière de silice (dépôt par évaporation) de 2 nm d'épaisseur + couche d'Optool DSX^{®} de 2 nm d'épaisseur
Exemple comparatif C10 : couche barrière de silice (dépôt par évaporation) de 4 nm d'épaisseur + couche d'Optool DSX^{®} de 2 nm d'épaisseur
Exemple comparatif C11 : couche barrière de silice (dépôt par centrifugation de TMOS hydrolysé) de 15 nm d'épaisseur
Exemple comparatif C12 : couche barrière de silice et de colloïdes de silice (dépôt par centrifugation de TMOS hydrolysé + NALCO^{®} 1034A) de 20 nm d'épaisseur

### Empilements substrat / revêtement anti-abrasion / couche HI / revêtement mésoporeux / couche barrière

Exemple 5 : couche barrière de silice (dépôt par évaporation) de 8 nm d'épaisseur + couche d'Optool DSX^{®} de 2 nm d'épaisseur
Exemple 6 : couche barrière de silice (dépôt par évaporation) de 10 nm d'épaisseur + couche d'Optool DSX^{®} de 2 nm d'épaisseur

### Evaluation de l'efficacité des couches barrières après dépôt de sébum artificiel

Du sébum artificiel, composé essentiellement d'acide oléique, est déposé par une technique de tamponnage à la surface des articles testés. La durée d'imprégnation, c'est à dire le temps laissé au sébum pour éventuellement polluer la couche mésoporeuse avant essuyage et/ou lavage du dépôt de sébum à l'eau savonneuse, va de 24h à 3 jours. Les articles sont alors caractérisés par mesure infrarouge, ellipsométrique ou par microscopie optique, afin d'évaluer l'efficacité de la protection de la porosité par la couche barrière.

### F) Moyens de caractérisation

Les articles d'optique préparés ont été analysés en utilisant les techniques suivantes :
- Spectre de réflexion (SMR).
- Spectroscopie infrarouge (IR) à transformée de Fourier (Appareil Bruker Vector 33). Pour chaque spectre, 15 accumulations sont réalisées avec une précision 4 cm⁻¹. Dans la zone 2500-3300 cm⁻¹, le spectre IR du sébum artificiel présente deux pics caractéristiques à 2914 et 2850 cm⁻¹ correspondant aux bandes de vibration des chaînes CH₂ des composés du sébum. Le suivi de l'évolution de ces bandes de vibration permet d'évaluer la pollution de la porosité du revêtement mésoporeux par le sébum, dans la limite de détection du spectroscope IR.

- Microscopie optique : Des couches mésoporeuses ont été déposées sur des substrats biplans afin de suivre par microscopie optique l'imprégnation de la salissure dans la porosité. Les images sont réalisées en réflexion à des grossissements variant de (x25) à (x200).
- Ellipsométrie multilongueur d'onde (Woolman), qui a permis le calcul d'indices de réfraction selon les modèles de calcul de Cauchy et EMA :

Pour cette étude, les couches mésoporeuses décrites ci-dessus (hydrophobation au HMDS, épaisseur 100 nm) ont été déposées sur des wafers de silicium. Des mesures d'indice de réfraction ont été réalisées par ellipsométrie avant et après le dépôt sous vide d'une couche de SiO₂ d'environ 10 nm d'épaisseur. Les valeurs sont consignées dans le tableau 1. Les modèles utilisés (Cauchy et EMA) supposent la présence d'une seule couche, ce qui est une approximation, vu qu'un dépôt de couche de silice a été effectué. La valeur MSE correspond au critère de confiance de la mesure. Une valeur inférieure à 50 est généralement considérée comme acceptable.

**Tableau 1**

| | Modèle Cauchy | | | Modèle EMA | | | |
|---|---|---|---|---|---|---|---|
| Configuration | Indice de réfraction | Epaisseur (nm) | MSE | Indice de réfraction | Epaisseur (nm) | Porosité (%) | MSE |
| Revêtement mésoporeux | 1,315 | 106 | 10,58 | 1,317 | 106 | 29,6 | 12,5 |
| Revêtement mésoporeux + SiO₂ 10 nm | 1,331 | 117 | 16,5 | 1,333 | 117,8 | 26,3 | 20 |
| Revêtement mésoporeux + SiO₂ 10 nm + Optool DSX^{®} 2 nm | 1,3309 | 127 | 20 | 1,331 | 127,8 | 26,7 | 23,46 |

Le tableau 1 montre une très légère variation de l'indice de réfraction après dépôt de la couche de SiO₂. Ces mesures montrent aussi que la porosité du revêtement mésoporeux n'est pas ou peu comblée par le dépôt de la couche de silice.

Lorsque l'on suppose dans les modèles la présence d'une seule couche, le calcul intègre les indices de réfractions de ces deux couches pour en faire une moyenne pondérée par les épaisseurs respectives des couches. Ainsi, si l'on calcule l'indice de réfraction pondéré par les épaisseurs en supposant que 1) l'indice de réfraction de la couche mésoporeuse est 1,315 pour une épaisseur de 106 nm et que 2) l'indice de réfraction de la couche de silice est de 1,48 pour une épaisseur de 11 nm, on obtient un indice de réfraction moyen pondéré de (1,315x106 + 1,48x11) / (106+11) = 1,3305. Cette valeur correspond à l'indice de réfraction mesuré par l'ellipsomètre avec un modèle monocouche.

### G) Résultats

Les trois techniques de caractérisation utilisées ont permis de mettre en évidence la contamination par le sébum d'une couche poreuse non revêtue d'une couche barrière selon l'invention et la non contamination par le sébum d'une couche poreuse revêtue d'une couche barrière selon l'invention.

Microscopie optique : La présence de sébum dans la porosité a été observée sur les articles comparatifs par microscopie optique (agrandissement x25). L'imprégnation de la salissure dans la porosité est clairement visible après une durée d'imprégnation de seulement 15 minutes. Après un essuyage partiel de la surface des articles, des tâches d'imprégnation résiduelles sont clairement identifiées.

Spectroscopie infrarouge : La présence de sébum dans la porosité a été observée par spectroscopie infrarouge sur les articles comparatifs. Les spectres réalisés 24h après dépôt de la salissure puis essuyage révèlent la présence de sébum dans la porosité, même après lavage à l'eau savonneuse (pics caractéristiques du sébum à 2914 et 2850 cm⁻¹). Le nettoyage à l'eau savonneuse permet seulement de retirer le sébum présent en surface de l'article.

Variation de l'indice de réfraction : Des dépôts de sébum artificiels ont été réalisés sur les articles testés. Les mesures d'indice de réfraction ont été effectuées par ellipsométrie après une période d'imprégnation de 24h, suivie d'un essuyage et d'un lavage à l'eau savonneuse.

En l'absence de couche barrière (le revêtement mésoporeux constitue dans ce cas la couche externe de l'empilement), en présence d'une couche barrière de silice trop fine (< 5 nm) accompagnée ou non d'une couche d'Optool DSX^{®}, ou en présence d'une couche barrière de MgF₂ (quelle que soit son épaisseur, de 2 à 8 nm) ou constituée d'Optool DSX^{®} (exemple C8), on constate que l'indice de réfraction du revêtement mésoporeux augmente d'une gamme d'indice de réfraction de 1,31-1,33 à une gamme d'indice de réfraction de 1,37-1,46, soit une variation d'indice de réfraction d'au moins 0,04 (cf. tableau 2). Les couches précitées ne constituent donc pas des couches barrières efficaces contre la pénétration de sébum dans la porosité du revêtement mésoporeux.

L'exemple C11 montre qu'une couche de silice issue de la condensation de TMOS (procédé sol-gel) ne permet pas de protéger le revêtement mésoporeux sous-jacent contre la pénétration de sébum. L'exemple C12 montre que la présence de colloïdes ne permet pas d'améliorer les propriétés protectrices d'une couche barrière de silice formée par voie liquide.

Il est à noter que le dépôt de ces couches de silice par voie liquide ne comble pas, ou du moins très peu, la porosité de la couche mésoporeuse sous-jacente. Effectivement, l'indice de réfraction mesuré (n=1,33), moyenne pondérée de l'indice de la couche barrière et de la couche mésoporeuse, implique un indice du revêtement mésoporeux de l'ordre de 1,308 correspondant à celui de la couche mésoporeuse +HDMS sans aucune surcouche (exemple 1).

Dans le cas des revêtements faisant barrière au sébum selon l'invention (exemples 1-6), aucune tâche d'imprégnation n'a été identifiée par microscopie optique. Aucune imprégnation résiduelle n'a non plus été observée après essuyage partiel de la surface des articles. Les spectres infrarouge réalisés 24h après dépôt de la salissure puis essuyage révèlent l'absence de sébum dans la porosité des articles selon l'invention.

Le tableau 2 montre que la variation d'indice de réfraction du revêtement mésoporeux de l'article d'optique, après imprégnation par du sébum artificiel de la surface des articles d'optique et essuyage, est beaucoup plus faible dans le cas des articles d'optique selon l'invention.

**Tableau 2**

| Exemple | n initial | n après essuyage | n après essuyage + lavage eau savonneuse | Δn |
|---|---|---|---|---|
| C1 | 1,308 | - | 1,397 | **0,089** |
| C2 | 1,327 | 1,404 | 1,398 | **0,071** |
| C3 | 1,335 | 1,374 | 1,370 | **0,035** |
| C4 | 1,322 | 1,447 | - | **0,125** |
| C5 | 1,319 | 1,438 | - | **0,119** |
| C6 | 1,319 | 1,456 | - | **0,137** |
| C7 | 1,319 | 1,436 | - | **0,117** |
| C8 | 1,333 | 1,443 | 1,396 | **0,063** |
| C9 | 1,325 | 1,368 | 1,366 | **0,041** |
| C10 | 1,333 | 1,358 | 1,366 | **0,033** |
| C11 | 1,335 | - | 1,464 | **0,129** |
| C12 | 1,345 | - | 1,397 | **0,052** |
| 1 | 1,334 | - | 1,342 | 0,008 |
| 2 | 1,329 | 1,355 | 1,343 | 0,014 |
| 3 | 1,347 | 1,356 | 1,357 | 0,010 |
| 4 | 1,332 | - | 1,338 | 0,006 |

Le tableau 3 indique les performances en réflexion de certains articles selon l'invention, mesurées au moyen d'un spectrophotomètre, immédiatement après leur préparation (sans mise en contact avec du sébum artificiel):

**Tableau 3**

| Exemple | h (°) | C* | Rₘ (%) | Rᵥ (%) |
|---|---|---|---|---|
| 2 | 302 | 9,4 | 0,7 | 0,43 |
| 4 | 282 | 17,5 | 1,14 | 0,67 |
| 5 | 239 | 7,2 | 0,56 | 0,47 |
| 6 | 251 | 9,4 | 0,68 | 0,54 |

Après 24 heures de contact avec le sébum artificiel, et essuyage :

| Exemple | h (°) | C* | Rₘ (%) | R_{V} (%) |
|---|---|---|---|---|
| 4 | 283 | 17,5 | 1,12 | 0,67 |
| 5 | 238 | 7,2 | 0,57 | 0,47 |
| 6 | 247 | 9,3 | 0,69 | 0,54 |

Après 24 heures de contact avec le sébum artificiel, essuyage et lavage à l'eau savonneuse :

| Exemple | h (°) | C* | Rₘ (%) | R_{V} (%) |
|---|---|---|---|---|
| 4 | 283 | 17,4 | 1,10 | 0,64 |
| 5 | 236 | 6,7 | 0,53 | 0,65 |
| 6 | 246 | 8,9 | 0,67 | 0,45 |

Les revêtements formant barrière au sébum selon l'invention apportent donc une protection efficace contre l'imprégnation du sébum dans le revêtement mésoporeux, pendant au moins 24 heures d'exposition permanente au sébum artificiel.

## Revendications

1. Article comprenant un substrat ayant une surface principale revêtue d'un revêtement mésoporeux et d'un revêtement faisant barrière au sébum d'épaisseur inférieure ou égale à 20 nm, déposé directement sur le revêtement mésoporeux, **caractérisé en ce que** le revêtement faisant barrière au sébum comporte au moins une couche à base de silice, ladite couche à base de silice :
- ayant une épaisseur d'au moins 5 nm,
- comprenant au moins 90 % en masse de silice, par rapport à la masse totale de la couche,
- ayant été déposée par dépôt physique en phase vapeur.

2. Article selon la revendication 1, **caractérisé en ce que** la couche à base de silice est en contact avec le revêtement mésoporeux.

3. Article selon la revendication 1 ou 2, **caractérisé en ce que** le revêtement faisant barrière au sébum comprend un revêtement antisalissure.

4. Article selon la revendication 3, **caractérisé en ce que** le revêtement antisalissure est obtenu à partir d'une composition polymérisable contenant des silanes ou silazanes porteurs de groupements fluorés.

5. Article selon la revendication 3 ou 4, **caractérisé en ce que** la couche à base de silice a une épaisseur supérieure ou égale à 8 nm.

6. Article selon l'une quelconque des revendications 3 à 5, **caractérisé en ce que** le revêtement antisalissure a une épaisseur allant de 2 à 10 nm.

7. Article selon la revendication 1 ou 2, **caractérisé en ce que** le revêtement faisant barrière au sébum consiste en ladite couche à base de silice.

8. Article selon l'une quelconque des revendications précédentes, **caractérisé en ce que** la couche à base de silice a une épaisseur supérieure à 10 nm.

9. Article selon l'une quelconque des revendications précédentes, **caractérisé en ce que** l'article est une lentille optique, de préférence une lentille ophtalmique.

10. Article selon l'une quelconque des revendications précédentes, **caractérisé en ce que** le revêtement mésoporeux constitue une couche d'un revêtement antireflet monocouche ou multicouche.

11. Article selon l'une quelconque des revendications précédentes, **caractérisé en ce que** le revêtement mésoporeux est un revêtement sol-gel à matrice comprenant des chaînons - Si-O-Si-.

12. Procédé d'obtention d'un article comportant un substrat ayant une surface principale revêtue d'un revêtement mésoporeux dont l'indice de réfraction est stable dans le temps, comprenant la formation par dépôt physique en phase vapeur, directement sur ledit revêtement mésoporeux, d'un revêtement faisant barrière au sébum tel que défini dans l'une quelconque des revendications 1 à 11, ledit revêtement faisant barrière au sébum comprenant au moins une couche à base de silice telle que définie dans l'une quelconque des revendications 1 à 11.

13. Procédé selon la revendication 12, **caractérisé en ce que** la couche à base de silice du revêtement faisant barrière au sébum est déposée par évaporation sous vide.

14. Utilisation d'un revêtement faisant barrière au sébum d'épaisseur inférieure ou égale à 20 nm, comportant au moins une couche à base de silice, pour empêcher la pénétration de sébum dans la porosité d'un revêtement mésoporeux formé sur une surface principale du substrat d'un article, **caractérisé en ce que** le revêtement faisant barrière au sébum est déposé directement sur le revêtement mésoporeux et **en ce que** ladite couche à base de silice :
- a une épaisseur d'au moins 5 nm,
- comprend au moins 90 % en masse de silice, par rapport à la masse totale de la couche,
- a été déposée par dépôt physique en phase vapeur.

## Patentansprüche

1. Gegenstand, umfassend ein Substrat mit einer Hauptoberfläche, die mit einer mesoporösen Beschichtung und einer direkt auf der mesoporösen Beschichtung abgeschiedenen Talgbarrierebeschichtung mit einer Dicke kleiner gleich 20 nm beschichtet ist, **dadurch gekennzeichnet, dass** die Talgbarrierebeschichtung mindestens eine Schicht auf Basis von Siliciumdioxid umfasst, wobei die Schicht auf Basis von Siliciumdioxid:
- eine Dicke von mindestens 5 nm aufweist,
- mindestens 90 Massen-% Siliciumdioxid, bezogen auf die Gesamtmasse der Schicht, umfasst,
- durch physikalische Gasphasenabscheidung abgeschieden worden ist.

2. Gegenstand nach Anspruch 1, **dadurch gekennzeichnet, dass** die Schicht auf Basis von Siliciumdioxid mit der mesoporösen Beschichtung in Kontakt steht.

3. Gegenstand nach Anspruch 1 oder 2, **dadurch gekennzeichnet, dass** die Talgbarrierebeschichtung eine schmutzabweisende Beschichtung umfasst.

4. Gegenstand nach Anspruch 3, **dadurch gekennzeichnet, dass** die schmutzabweisende Beschichtung aus einer polymerisierbaren Zusammensetzung, die Silane oder Silazane mit fluorierten Gruppen enthält, erhalten wird.

5. Gegenstand nach Anspruch 3 oder 4, **dadurch gekennzeichnet, dass** die Schicht auf Basis von Siliciumdioxid eine Dicke größer gleich 8 nm aufweist.

6. Gegenstand nach einem der Ansprüche 3 bis 5, **dadurch gekennzeichnet, dass** die schmutzabweisende Beschichtung eine Dicke im Bereich von 2 bis 10 nm aufweist.

7. Gegenstand nach Anspruch 1 oder 2, **dadurch gekennzeichnet, dass** die Talgbarrierebeschichtung aus der Schicht auf Basis von Siliciumdioxid besteht.

8. Gegenstand nach einem der vorhergehenden Ansprüche, **dadurch gekennzeichnet, dass** die Schicht auf Basis von Siliciumdioxid eine Dicke von mehr als 10 nm aufweist.

9. Gegenstand nach einem der vorhergehenden Ansprüche, **dadurch gekennzeichnet, dass** es sich bei dem Gegenstand um eine optische Linse, vorzugsweise eine ophthalmische Linse, handelt.

10. Gegenstand nach einem der vorhergehenden Ansprüche, **dadurch gekennzeichnet, dass** die mesoporöse Beschichtung eine Schicht einer ein- oder mehrschichtigen Antireflexbeschichtung darstellt.

11. Gegenstand nach einem der vorhergehenden Ansprüche, **dadurch gekennzeichnet, dass** es sich bei der mesoporösem Beschichtung um eine Sol-Gel-Beschichtung mit einer Matrix mit "Si-O-Si-Gliedern handelt.

12. Verfahren zur Herstellung eines Gegenstands mit einem Substrat mit einer Hauptoberfläche, die mit einer mesoporösen Beschichtung beschichtet ist, deren Brechungsindex zeitlich stabil ist, bei dem man durch physikalische Gasphasenabscheidung direkt auf der mesoporösen Beschichtung eine Talgbarrierebeschichtung gemäß einem der Ansprüche 1. bis 11 bildet, wobei die Talgbarrierebeschichtung mindestens eine Schicht auf Basis von Siliciumdioxid gemäß einem der Ansprüche 1 bis 11 umfasst.

13. Verfahren nach Anspruch 12, **dadurch gekennzeichnet, dass** die Schicht auf Basis von Siliciumdioxid der Talgbarrierebeschichtung durch Vakuumverdampfung abgeschieden wird.

14. Verwendung einer Talgbarrierebeschichtung mit einer Dicke kleiner gleich 20 nm, die mindestens eine Schicht auf Basis von Siliciumdioxid umfasst, zur Verhinderung des Eindringens von Talg in den Porenraum einer auf einer Hauptoberfläche des Substrats eines Gegenstands gebildeten mesoporösen Beschichtung, **dadurch gekennzeichnet, dass** die Talgbarrierebeschichtung direkt auf der mesoporösen Beschichtung abgeschieden ist und die Schicht auf Basis von Siliciumdioxid:
- eine Dicke von mindestens 5 nm aufweist,
- mindestens 90 Massen-% Siliciumdioxid, bezogen auf die Gesamtmasse der Schicht, umfasst,
- durch physikalische Gasphasenabscheidung abgeschieden worden ist.

## Claims

1. An article comprising a substrate, having a main surface coated with a mesoporous coating and a coating acting as a barrier to sebum having a thickness lower than or equal to 20 nm directly deposited onto the mesoporous coating, **characterized in that** the coating acting as a barrier to sebum comprises at least one silica-based layer, said silica-based layer:
- having a thickness of at least 5 nm,
- comprising at least 90% by weight of silica, relative to the layer total weight, and
- having been deposited by physical vapor deposition.

2. The article of claim 1, wherein the silica-based layer is in contact with the mesoporous coating.

3. The article of claim 1 or 2, wherein the coating acting as a barrier to sebum comprises an anti-fouling coating.

4. The article of claim 3, wherein the anti-fouling coating is obtained from a polymerizable composition containing silanes or silazanes bearing fluorinated moieties.

5. The article of claim 3 or 4, wherein the silica-based layer has a thickness higher than or equal to 8 nm.

6. The article of any one of claims 3 to 5, wherein the anti-fouling coating has a thickness ranging from 2 to 10 nm.

7. The article of claim 1 or 2, wherein the coating acting as a barrier to sebum consists in said silica-based layer.

8. The article of any one of the preceding claims, wherein the silica-based layer has a thickness higher than 10 nm.

9. The article of any one of the preceding claims, wherein the article is an optical lens, preferably an ophthalmic lens.

10. The article of any one of the preceding claims, wherein the mesoporous coating is a layer of a monolayered or multilayered anti-reflection coating.

11. The article of any one of the preceding claims, wherein the mesoporous coating is a sol-gel coating with a matrix containing -Si-O-Si- chain members.

12. A method for preparing an article having a substrate, the main surface of which is coated with a mesoporous coating, the refractive index of which is stable over time, comprising forming by physical vapor deposition, directly onto said mesoporous coating, a coating acting as a barrier to sebum such as defined in any one of claims 1 to 11, said coating acting as a barrier to sebum comprising at least one silica-based layer such as defined in any one of claims 1 to 11.

13. The method of claim 12, wherein the silica-based layer of the coating acting as a barrier to sebum is deposited by evaporation under vacuum.

14. The use of a coating acting as a barrier to sebum having a thickness lower than or equal to 20 nm, comprising at least one silica-based layer, to prevent the penetration of sebum into the porosity of a mesoporous coating formed on a main surface of the substrate of an article, **characterized in that** the coating acting as a barrier to sebum is directly deposited onto the mesoporous coating, and **in that** said silica-based layer:
- has a thickness of at least 5 nm,
- comprises at least 90% by weight of silica, relative to the layer total weight, and
- has been deposited by physical vapor deposition.
